# EUROPÄISCHE PATENTSCHRIFT

(11) **EP 2 867 905 B1**
(45) Veröffentlichungstag und Bekanntmachung des Hinweises auf die Patenterteilung: **08.02.2017**
(21) Anmeldenummer: 13731720.2
(22) Anmeldetag: 19.06.2013
(51) Int. Cl.: H05K 3/40, H05K 1/16, H01C 10/50, H01C 10/48, H01H 19/58

(54) **KÜCHENGERÄT ZUM VERARBEITEN VON NAHRUNGSMITTELN MIT EINEM STEUERUNGSMODUL**
KITCHEN APPLIANCE FOR PROCESSING FOODSTUFFS, WITH A CONTROLLER MODULE
APPAREIL DE CUISINE DESTINÉ À TRANSFORMER DES ALIMENTS, DOTÉ D'UN MODULE DE COMMANDE

(30) Priorität: 29.06.2012 DE 102012013011
(43) Veröffentlichungstag der Anmeldung: 06.05.2015
(73) Patentinhaber: BSH Hausgeräte GmbH, 81739 München (DE)
(72) Erfinder: KOVACIC, Peter, 3303 Gomilsko (SI); ZAGER, Igor, 3320 Velenje (SI)
(86) Internationale Anmeldenummer: PCT/EP2013/062693
(87) Internationale Veröffentlichungsnummer: WO 2014/001163

(56) Entgegenhaltungen:
- DE-A1- 2 260 019
- DE-A1-102009 003 118
- US-A- 4 090 167
- US-A- 4 679 025

## Beschreibung

### Hintergrund der Erfindung

Die Erfindung betrifft ein Küchengerät zum Verarbeiten von Nahrungsmitteln gemäß dem Oberbegriff des Anspruchs 1.

### Stand der Technik

Küchengeräte weisen üblicherweise eine Handhabe bzw. einen Bedienknopf auf mit welchem ein Benutzer die Funktionsweise des Küchengeräts steuern kann. Insbesondere kann der Benutzer mit Hilfe der Handhabe den Elektromotor steuern, d.h. seine gewünschte Rotationsgeschwindigkeit einstellen. Dies ist notwendig, damit unterschiedliche Nahrungsmittel entsprechend verarbeitet werden können. Die Handhabe wird üblicherweise in ihrem Mittelpunkt am Gerät fixiert, so dass durch Drehung des Drehknopfes eine Vielzahl an Positionen einstellbar ist, die jeweils unterschiedlichen Betriebszuständen des Motors entsprechen. Um dies zu implementieren weisen Küchengeräte Potentiometerschaltungen auf, die insbesondere als Drehpotentiometer ausgebildet sind. Anhand der Potentiometerstellung, d.h. des Widerstandwertes, kann dann die entsprechende Funktion des Küchengeräts geregelt werden.

Potentiometer können als Einzelbauteile verwendet werden, die aber relativ teuer in der Herstellung sind, oder auch eine im Steuermodul integrale Lösung einsetzbar, die wiederum viele Nachteile aufweist. So ist beispielsweise bei der Integrallösung lediglich ein eingeschränkter Drehbereich verwendbar, der sich durch die Hardwaregegebenheiten ergibt.

Aus DE-OS 22 60 019 ist beispielsweise ein Vielfach-Stufendrehschalter bekannt mit einem Stator, der aus einem Isolierringkörper mit nach innen vorstehenden Kontaktzungen besteht, und einem Rotor, der wenigstens einen an einer Seite der Kontaktzungen angreifenden Umschaltkontakt aufweist. Auf der von dem Umschaltkontakt abgewandten Seite der Kontaktzungen ist ein Isolierring am Stator befestigt. Der Isolierring weist zwischen den Kontaktzungen in Richtung der letzteren vorstehende Rippen auf, welche nahe den Kontaktzungen liegen, jedoch keine Verbindung mit diesen haben. Durch die Rippen des Isolierrings werden die beweglichen Umschaltkontakte beim Weiterschalten von einer Kontaktzunge zur nächsten zwischen den Kontaktzungen abgestützt, so dass ein Kurzschluss zwischen den Kontaktzungen wirksam vermieden ist.

Weiter offenbart die US 10 2009 003118 A1 ebenfalls ein Küchengerät mit einem Steuerungsmodul und einem Bedienteil für den Elektromotor. Steuerungsmodule sind auch in der US 4 090 167 A und US 4 679 025 A beschrieben.

Nachteilig im Stand der Technik ist es jedoch, dass der konstruktive Aufbau des Stufendrehschalters sehr aufwendig ist und eine Anpassung des Stufendrehschalters an unterschiedliche Schaltmuster für verschieden elektrische Geräte nicht möglich bzw. nur mit erheblichem Aufwand möglich ist.

### Der Erfindung zugrundeliegende Aufgabe

Daher ist Aufgabe der Erfindung ein Küchengerät mit einem Steuerungsmodul bereitzustellen, das einen möglichst weiten Regelbereich aufweist.

### Erfindungsgemäße Lösung

Die Lösung der gestellten Aufgabe gelingt durch ein Küchengerät mit den Merkmalen des Anspruchs 1. Vorteilhafte Aus- und Weiterbildungen, welche einzeln oder in Kombination miteinander eingesetzt werden können, sind Gegenstand der abhängigen Ansprüche.

Das erfindungsgemäße Küchengerät zum Verarbeiten von Nahrungsmitteln weist einen Elektromotor und einen Steuerungsmodul für den Elektromotor auf. Das Steuerungsmodul umfasst eine Leiterplatte für elektrische und/oder elektronische Bauelemente, wobei die Leiterplatte zumindest einen ersten und einen zweiten Kontaktpol aufweist, die zur Steuerung des Elektromotors mit einer Schaltbrücke zusammenwirken, wobei die Kontaktpole länglich ausgebildet sind und zumindest abschnittsweise parallel verlaufen. Die zwei Kontaktpole sind länglich, insbesondere bahnförmig auf der Leiterplatte, ausgebildet und verlaufen im Wesentlichen in ihrer Längsrichtung zumindest abschnittsweise parallel. So kann die Schaltbrücke einen weiten Einstellungsbereich bzw. Regelbereich für das Steuerungsmodul abdecken, wobei die kompakte Bauweise des Küchengeräts weiterhin aufrechterhalten werden kann. Durch die parallele Ausführung der Kontaktpole können unterschiedliche Betriebsarten für den Elektromotor bereitgestellt werden, ohne dass weitere Handhaben oder weitere Elektronikmodule eingesetzt werden müssen. Folglich kann ein Drehknopf eine Vielzahl an Funktionen aufweisen, welche wiederum mittels der Steuerbrücke in elektrischer Verbindung mit den Kontaktpolen des Steuerungsmoduls abbildbar sind. Das Steuerungsmodul kann weiter einen Mikroprozessor umfassen, der die Stellungen der Schaltbrücke d.h. die Einstellungen des Benutzers, verarbeiten und entsprechend den Elektromotor steuern kann. Die in Längsrichtung der Kontaktpole parallele Bauweise erlaubt einen kompakten und weiten Einstellbereich (oder Regelbereich) für das Steuerungsmodul. Somit kann das Küchengerät in seine Gesamtheit besonders kompakt und platzsparend realisiert werden

### Bevorzugte Ausgestaltung der Erfindung

Es wird bevorzugt, dass die der erste Kontaktpol als erste Widerstandsschicht auf der Leiterplatte ausgebildet ist. Folglich kann der Kontaktpol als Teil einer Potentiometerarchitektur integral auf der Leiterplatte des Steuerungsmoduls implementiert werden. Mit Hilfe der Widerstandsschicht und der Schaltbrücke können wiederum unterschiedliche Widerstandswerte eingestellt werden, welche somit Betriebsarten des Elektromotors entsprechen. Diesen Betriebsarten können beispielsweise unterschiedliche Drehzahlen des Motors entsprechen. Eine weitere Elektronik, insbesondere ein Mikroprozessor, verarbeitet den eingestellten Widerstandswert und steuert den Motor gemäß der Benutzereinstellung, die an einen Drehknopf des Küchengeräts durchführbar ist.

Auch der zweite Kontaktpol kann als zweite Widerstandsschicht oder als Leiterschicht im Wesentlichen in derselben Ebene wie der erste Kontaktpol auf der Leiterplatte ausgebildet sein. Folglich kann eine kompakte und einfach herzustellende Potentiometerarchitektur auf der Leiterplatte integral hergestellt werden. Da der variable Widerstand im Wesentlichen mittels des ersten Kontaktpols eingestellt wird, kann der zweite Kontaktpol auch als Leiter ausgebildet sein, an welchem kein regelbarer Widerstandswert einstellbar ist.

Erfindungsgemäß ist der erste Kontaktpol als Ringsektor und der zweite Kontaktpol als Ring ausgebildet, dergestalt, dass die Kontaktpole konzentrisch verlaufen. Somit kann ein besonders weiter Einstellbereich für den variablen Widerstandswert realisiert werden, und gleichzeitig bleibt die kompakte Bauweise des Küchengeräts weiterhin bestehen.

Insbesondere weist der als Ringsektor ausgebildete erste Kontaktpol einen Mittelpunktswinkel von insbesondere 45° bis 350°, bevorzugt 45° bis 270°, besonders bevorzugt 45° bis 190° auf. Folglich können eine Vielzahl an Betriebspositionen des Drehknopfes des Küchengeräts platzsparend implementiert werden.

Vorteilhafterweise sind die Kontaktpole auf der Leiterplatte als Widerstandsschicht bedruckt. Demgemäß kann das Herstellungsverfahren effizient durchgeführt werden, und die Leiterplatte weist dann ein integral ausgebildetes Potentiometer auf.

Die Schaltbrücke umfasst ein elektrisch leitendes Material und weiter einen ersten und einen zweiten Schleifkontakt, die ausgebildet sind die entsprechenden Kontaktpole elektrisch zu kontaktieren. Somit kann eine funktionelle Verbindung zwischen den Kontaktpolen bereitgestellt werden, damit der einstellbare Widerstandswert folglich zur Motorsteuerung verwendet werden kann.

An den Schleifkontakten sind jeweils zwei Federzungen mit Kontaktstelle zum Kontaktieren der Kontaktpole ausgebildet. Diese insbesondere elastisch ausgebildeten Federzungen sind besonders robust und erlauben eine genaue Einstellung des Widerstandswertes. Gleichzeitig können Fertigungstolleranzen der Schaltbrücke kompensiert werden.

Die Schaltbrücke ist vorteilhafterweise in einer Fassung befestigt, die als Teil eines Drehknopfes des Küchengeräts ausgebildet ist. Somit kann eine direkte Verbindung zwischen der Handhabe des Geräts und der elektronischen Steuerung bereitgestellt werden.

Gemäß der vorliegenden Erfindung wirkt die Schaltbrücke mit dem ersten Kontaktpol derart zusammenwirkt, dass ein einstellbarer Widerstandswert zur Steuerung des Elektromotors des Küchengeräts bereitstellbar ist. Somit kann ein variabler Widerstandswert zur Motorsteuerung verwendet werden, um somit unterschiedliche Betriebsarten des Küchengeräts zu erlauben.

### Kurzbeschreibung der Zeichnungen

Weitere vorteilhafte Ausgestaltungen werden nachfolgend an Hand von in der Zeichnung dargestellten Ausführungsbeispielen, auf welche die Erfindung jedoch nicht beschränkt ist, näher beschrieben.

Es zeigen schematisch:
- Fig. 1: eine erste Ansicht eines Steuerungsmoduls gemäß der vorliegenden Erfindung;
- Fig. 2: eine zweite Ansicht des Steuerungsmoduls gemäß der vorliegenden Erfindung;
- Fig. 3: eine Draufsicht auf das Steuerungsmodul samt Schaltbrücke gemäß der Erfindung; und schließlich
- Fig.4: eine Handhabe bzw. einen Drehknopf für das erfindungsgemäße Küchengerät.

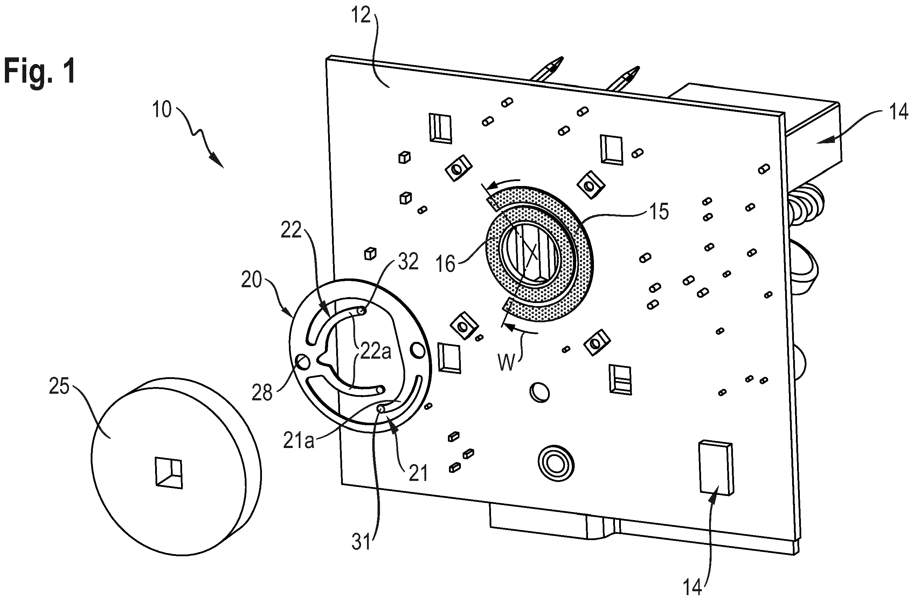

Fig. 1 zeigt ein Steuerungsmodul 10 eines nicht näher dargestellten Küchengeräts. Bei dem Küchengerät kann es sich insbesondere um eine Küchenmaschine oder einen Food Processors handeln, die für die Bearbeitung von unterschiedlichen Nahrungsmitteln einsetzbar sind. Das Küchengerät weist üblicherweise eine Verarbeitungsschüssel, in der unterschiedliche Werkzeuge mittels eines Elektromotors rotierend angetrieben werden können.

Mit Hilfe des erfindungsgemäßen Steuerungsmoduls 10 und der entsprechenden Handhabe bzw. des entsprechenden Drehknopfes 40, kann ein Benutzer die gewünschte Rotationsgeschwindigkeit bzw. Betriebsart des Küchengeräts einstellen. Zum Verarbeiten von Teig ist beispielsweise eine niedrige Drehzahl notwendig, und wiederum zum Zerkleinern von anderen Lebensmitteln kann eine hohe Drehzahl notwendig sein. All diese Funktionen sollen möglichst einfach und auch platzsparend in einem Steuerungsmodul 10 implementiert sein.

Der Übersichtlichkeit halber wurde auf die Darstellung des kompletten Küchengeräts verzichtet und lediglich eine Explosionsdarstellung des Steuerungsmoduls 10 samt wichtigsten Komponenten gezeigt.

Das Steuerungsmodul weist eine Leiterplatte 12 auf, welche unterschiedliche elektronische Bauelemente 14 aufweist, die wiederum elektrisch in Verbindung stehen. Dies wird üblicherweise mittels Leiterbahnen oder desgleichen auf der Leiterplatte 12 bereitgestellt. Zur Drehzahlsteuerung weist das Steuerungsmodul eine Potentiometerarchitektur mit zwei länglich ausgebildeten Widerstandsschichten 15, 16 auf. Die zwei Schichten 15, 16 bilden zwei funktionale Kontaktpole 15 und 16 für eine dazu passende Schaltbrücke 20. Die Schaltbrücke 20 ist dann in eine entsprechende Fassung 25 eines Drehknopfes 40 des Küchengeräts fixiert.

Die zwei als Widerstandsschicht 15, 16 ausgebildeten Kontaktpole der Potentiometerarchitektur können in einer Ebene auf der Leiterplatte 12 aufgedruckt sein, und sind gemäß der Erfindung konzentrisch angeordnet. Der erste Kontaktpol 15 ist als Ringsektor mit einem Mittelpunktwinkel von etwa 270° ausgebildet, wobei der zweite Kontaktpol als konzentrischer Ring 16 innerhalb des ersten Ringsektors 15 angeordnet ist. Beide Kontaktpole 15, 16 sind im einer möglichen Ausführungsform als Widerstandsschicht auf der Leiterplatte 12 angeformt bzw. aufgedruckt.

Möglich ist auch dass beispielsweise der zweite Kontaktpol im Wesentlichen als leitender Kontaktbereich (nicht gezeigt) für die Schaltbrücke ausgebildet ist, so dass z.B. Widerstandsmaterial auf der Leiterplatte 12 gespart werden könnte.

Gemäß der Erfindung bildet der erste Kontaktpol 15 einen variablen Widerstandswert, der mittels der Schaltbrücke 20 einstellbar ist. Dazu weist die Schaltbrücke 20 eine, insbesondere elastische, Federzunge 21 a auf. Am Ende der Federzunge 21 a ist ein Schleifpunkt 31, z.B. ein Lötpunkt, ausgebildet, der direkt mit dem ersten Kontaktpol, d.h. mit der Widerstandsschicht 15, in elektrischer Verbindung steht. Der Kontaktpunkt 31 schleift demnach immer auf der Widerstandsschicht 15 und stellt somit den gewünschten Widerstandswert für das Steuerungsmodul 10 bereit. Der Widerstandswert kann unterschiedliche Werte annehmen, die durch den Spannwinkel W des ersten Kontaktpols 15 definiert sind.

Um die oben erwähnte Potentiometerarchitektur bereitzustellen, weist die Schaltbrücke 20 zwei weitere Federzungen 22a, 22b mit entsprechenden Kontaktpunkten 32, die wiederum auf dem Widerstandsring (zweiter Kontaktpol) 16 entlang schleifen und somit die elektrische Verbindung bereitstellen. Zwar sind hier zwei Federzungen 22a für den zweiten Kontaktpol 16 implementiert, jedoch könnte auch eine alternative Ausbildung mit weniger oder mehr Federzungen realisierbar. Dasselbe gilt für die Federzunge für den ersten Kontaktpol 15, jedoch hier muss wegen des einstellbaren, variablen Widerstandes eine entsprechende Kalibrierung durchgeführt werden.

Die Schaltbrücke 20 wird in einer Fassung 25 fixiert, so dass diese mittels eines Drehknopfes 40 durch einen Benutzer des Küchengeräts rotierend bedient werden kann. Entsprechend schleifen die Federzungen 22 und 21 mit ihren entsprechenden Kontakten 31 und 32 auf den Kontaktpolen, um somit eine erfindungsgemäße Potentiometerarchitektur bereitzustellen.

Die Schaltbrücke 20 ist in ihrer Außenkontur zumindest annähernd kreisförmig gestaltet. In etwa tangentialer Richtung sind die Federzungen 21, 22 an die kreisscheibenförmige Schaltbrücke 20 ausgerichtet. An den freien Enden der Federzungen 21, 22 sind jeweils Kontaktpunkt 31, 32, wie oben erwähnt, angebracht. Wie gezeigt kann eine oder auch mehrere Kontaktzungen 21, 22 zweiteilig ausgebildet sein. Dabei kann die Kontaktzunge 22 zwei federnde frei Enden auf, wobei jedes freie Ende einen eigenen Kontaktpunkt trägt. In der Schaltbrücke 20 sind eine oder mehrere Bohrungen 28 vorgesehen, die für eine richtige Winkellagezuordnung von Schaltbrücke 18 und Fassung 25 sorgt. Dazu kann an der Fassung 25 beispielsweise ein Stift oder desgleichen angeformt sein, der in der montierten Lage der Schaltbrücke 22 in der Fassung 25 in die Bohrung 28 eingesteckt ist.

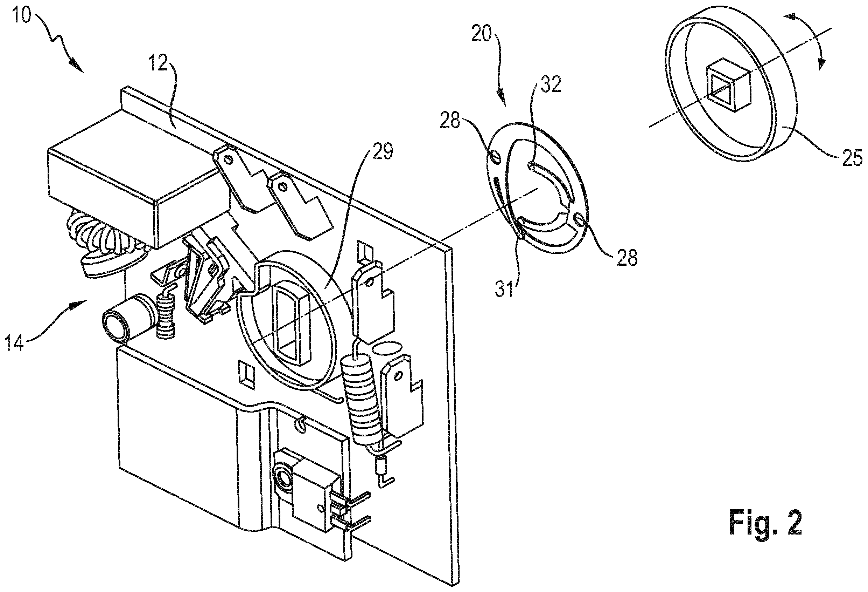

Fig. 2 ist eine Explosionsdarstellung des Steuerungsmoduls 10 nach Fig. 1 als Rückansicht. Hier ist ein weiters Teil 29 auf der Leiterplatte 12, das mit der Fassung 25 und der Schaltbrücke zusammenwirkt, so dass ein Benutzer mit Hilfe des Drehknopfes 40 das Küchengerät bedienen kann. Der Drehknopf 40 steht in Verbindung mit dem Teil 29 und weiter mit der Fassung 25, so dass eine Steuerung der Drehzahl realisierbar ist. Der Doppelpfeil an der Fassung 25 zeigt schematisch die Drehrichtung des Drehknopfes 40 an.

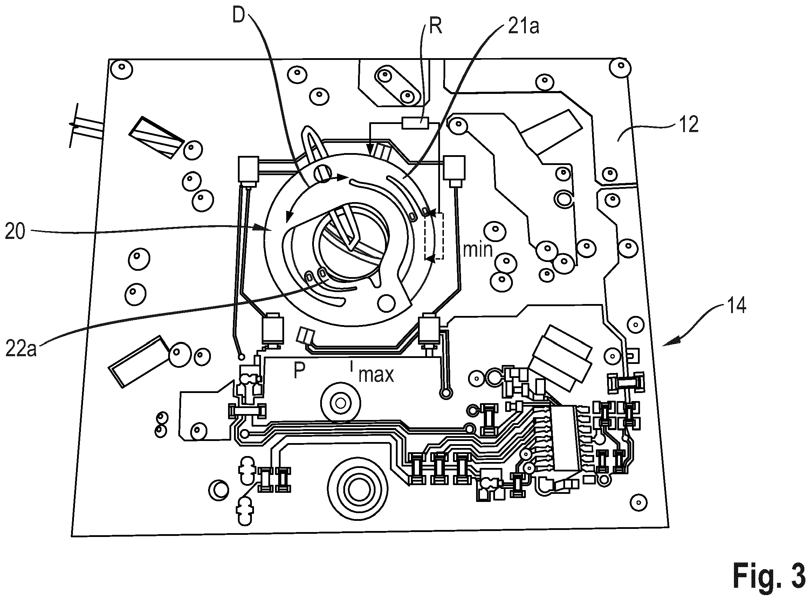

Fig. 3 ist eine Draufsicht auf das Steuerungsmodul gemäß der Erfindung, wobei eine zweite Ausführungsform der Schaltbrücke 20 zum Einsatz kommt. Wie oben beschrieben weist auch diese zweite Schaltbrücke eine Vielzahl an Federzungen 21a und 22a mit entsprechenden Kontaktpunkten 31, 32. Die Kontaktpunkte 31, 32 stellen eine elektrische Verbindung zu den als Widerstandsschicht ausgebildeten Kontaktpole 15, 16 bereit. Mit D ist die Drehrichtung der Schaltbrücke 20 schematisch dargestellt, die mittels der Fassung 25 in Verbindung mit dem Drehknopf 40 durch den Benutzer durchgeführt wird.

Weiter ist schematisch der variable Widerstand R dargestellt, der mittels der Schaltbrücke 20 und erstem Kontaktpol 15, d.h. aufgedruckter Widerstandsschicht, einstellbar ist. Durch Drehung entlang der Drehrichtung D können folglich eine Vielzahl an Widerstandswerten R eingestellt werden, die wiederum für die Steuerung des Elektromotors verwendet werden. Da der zweite Kontaktpol 16 symmetrisch angeschlossen ist, kann alleine der Widerstand R zur Motorsteuerung eingesetzt werden. Daher könnte beispielsweise der zweite Kontaktpol 16 auch als Leiterschicht oder Kontaktpunkt implementiert werden. In diesem Fall müsste aber die Schaltbrücke 20 eine andere Form aufweisen.

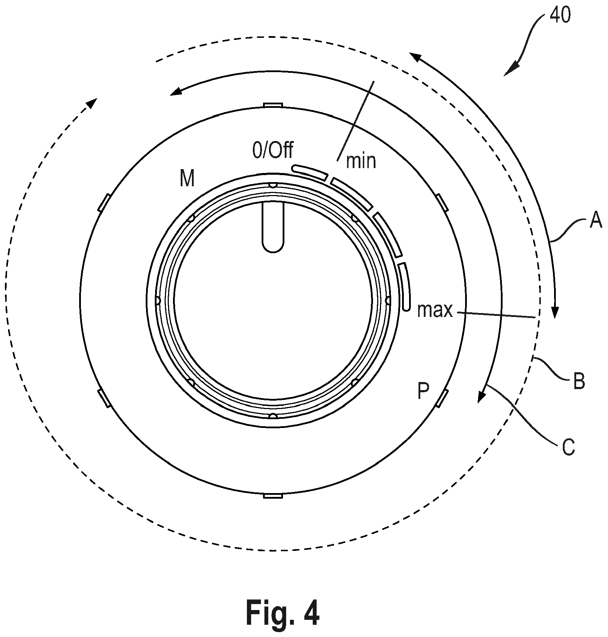

Fig. 4 ist eine schematische Darstellung eines Drehknopfes 40 für das Küchengerät, welches nicht dargestellt ist. Durch Drehung des Drehknopfes wir folglich die Schaltbrücke 20 mitbewegt so dass unterschiedliche Betriebsarten des Elektromotors einstellbar sind. Jede dieser Betriebsart entspricht einem bestimmten Widerstandswert R (vgl. Fig. 3), wobei die M-Stellung einer ersten Drehzahl entspricht, "min" der kleinsten Drehzahl und "max" demnach der Maximaldrehzahl. P könnte beispielsweise einem Pulsbetrieb entsprechen, der vom Steuerungsmodul 10 des Küchengeräts geregelt wird. A, B und C zeigen schematisch unterschiedliche Drehwinkel, wobei durch das erfindungsgemäße Steuerungsmodul über 270° (Winkel B) einstellbar sind. Somit steht ein sehr weiter Winkelbereich bereit, so dass der Drehknopf eine Vielzahl an Funktionen abbilden kann.

Durch die vorliegende Erfindung wird ein Küchengerät mit einem Steuerungsmodul bereitgestellt, das einen flexiblen Einstellbereich vorweist, wobei durch die erfindungsgemäße Ausbildung der Kontaktpole einen sehr großen Einstellbereich eines Drehknopfes des Küchengeräts bereitstellt.

## Patentansprüche

1. Küchengerät zum Verarbeiten von Nahrungsmitteln mit einem Elektromotor und einem Steuerungsmodul (10) für den Elektromotor, wobei das Steuerungsmodul (10) eine Leiterplatte (12) für elektrische und/oder elektronischen Bauelemente (14) aufweist, **wobei** die Leiterplatte (12) zumindest einen ersten und einen zweiten Kontaktpol (15, 16) aufweist, die zur Steuerung des Elektromotors mit einer Schaltbrücke (20) zusammenwirken, wobei die Kontaktpole (15, 16) länglich ausgebildet sind und zumindest abschnittsweise parallel verlaufen, **dadurch gekennzeichnet, dass** der erste Kontaktpol (15) als Ringsektor und der zweite Kontaktpol (16) als Ring ausgebildet ist, dergestalt, dass die Kontaktpole (15, 16) konzentrisch verlaufen..

2. Küchengerät nach Anspruch 1, **dadurch gekennzeichnet, dass** der erste Kontaktpol (15) als erste Widerstandsschicht auf der Leiterplatte (12) ausgebildet ist.

3. Küchengerät nach Anspruch 1 oder 2, **dadurch gekennzeichnet, dass** der zweite Kontaktpol (16) als zweite Widerstandsschicht oder als Leiterschicht im Wesentlichen in derselben Ebene wie der erste Kontaktpol (15) auf der Leiterplatte (12) ausgebildet ist.

4. Küchengerät nach Anspruch 1, **dadurch gekennzeichnet, dass** der als Ringsektor ausgebildete erste Kontaktpol (15) einen Mittelpunktswinkel von insbesondere 45° bis 350°, bevorzugt 45° bis 270°, besonders bevorzugt 45° bis 190° aufweist.

5. Küchengerät nach irgendeinem der vorhergehenden Ansprüche, **dadurch gekennzeichnet, dass** die Kontaktpole (15, 16) auf der Leiterplatte (12) als Widerstandsschicht bedruckt sind.

6. Küchengerät nach irgendeinem der vorhergehenden Ansprüche, **dadurch gekennzeichnet, dass** die Schaltbrücke (20) ein elektrisch leitendes Material umfasst und weiter einen ersten und einen zweiten Schleifkontakt (21, 22) aufweist, die ausgebildet sind die entsprechenden Kontaktpole (15, 16) elektrisch zu kontaktieren.

7. Küchengerät nach Anspruch 6, **dadurch gekennzeichnet, dass** die Schleifkontakte (21, 22) jeweils zwei Federzungen (21 a, 22a) mit Kontaktstelle (31, 32) zum Kontaktieren der Kontaktpole (15, 16) aufweisen.

8. Küchengerät nach irgendeinem der vorhergehenden Ansprüche, **dadurch gekennzeichnet, dass** die Schaltbrücke (20) in einer Fassung (25) befestigt ist, die als Teil eines Drehknopfes (40) des Küchengeräts ausgebildet ist.

9. Küchengerät nach irgendeinem der vorhergehenden Ansprüche, **dadurch gekennzeichnet, dass** die Schaltbrücke (20) mit dem ersten Kontaktpol (15) derart zusammenwirkt, dass ein einstellbarer Widerstandswert zur Steuerung des Elektromotors des Küchengeräts bereitstellbar ist.

## Claims

1. Kitchen appliance for processing foodstuffs, having an electric motor and a control module (10) for the electric motor, wherein the control module (10) has a printed circuit board (12) for electrical and/or electronic components (14), wherein the printed circuit board (12) has at least one first and one second contact pole (15, 16) which interact with a switching bridge (20) to control the electric motor, wherein the contact poles (15, 16) are embodied as elongated and run in parallel at least in certain sections, **characterised in that** the first contact pole (15) is embodied as a ring sector and the second contact pole (16) is embodied as a ring, such that the contact poles (15, 16) run concentrically.

2. Kitchen appliance according to claim 1, **characterised in that** the first contact pole (15) is embodied as a first resistor layer on the printed circuit board (12).

3. Kitchen appliance according to claim 1 or 2, **characterised in that** the second contact pole (16) is embodied as a second resistor layer or as a conductor layer in essentially the same plane as the first contact pole (15) on the printed circuit board (12).

4. Kitchen appliance according to claim 1, **characterised in that** the first contact pole (15) embodied as a ring sector has a central angle of in particular 45° to 350°, preferably 45° to 270°, particularly preferably 45° to 190°.

5. Kitchen appliance according to any one of the preceding claims, **characterised in that** the contact poles (15, 16) are printed on the printed circuit board (12) as a resistor layer.

6. Kitchen appliance according to any one of the preceding claims, **characterised in that** the switching bridge (20) comprises an electrically conductive material and further has a first and a second sliding contact (21, 22) which are embodied to electrically contact the respective contact poles (15, 16).

7. Kitchen appliance according to claim 6, **characterised in that** the sliding contacts (21, 22) each comprise two spring tongues (21a, 22a) with a contact point (31, 32) for contacting the contact poles (15, 16).

8. Kitchen appliance according to any of the preceding claims, **characterised in that** the switching bridge (20) is fastened in a mount (25), which is embodied as part of a rotary knob (40) of the kitchen appliance.

9. Kitchen appliance according to any one of the preceding claims, **characterised in that** the switching bridge (20) interacts with the first contact pole (15) such that an adjustable resistance for controlling the electric motor of the kitchen appliance can be provided.

## Revendications

1. Appareil de cuisine destiné à transformer des aliments, comprenant un moteur électrique et un module de commande (10) pour le moteur électrique, le module de commande (10) présentant un circuit imprimé (12) pour des composants (14) électriques et/ou électroniques, le circuit imprimé (12) présentant au moins un premier et un deuxième pôles de contact (15, 16) qui coopèrent avec un pont de commutation (20) pour la commande du moteur électrique, les pôles de contact (15, 16) étant réalisés de manière oblongue et s'étendant parallèlement au moins par sections, **caractérisé en ce que** le premier pôle de contact (15) est réalisé comme secteur annulaire et **en ce que** le deuxième pôle de contact (16) est réalisé comme bague, de manière à ce que les pôles de contact (15, 16) s'étendent de manière concentrique.

2. Appareil de cuisine selon la revendication 1, **caractérisé en ce que** le premier pôle de contact (15) est réalisé sur le circuit imprimé (12) comme première couche résistive.

3. Appareil de cuisine selon la revendication 1 ou 2, **caractérisé en ce que** le deuxième pôle de contact (16) est réalisé sur le circuit imprimé (12) comme deuxième couche résistive ou comme couche de circuit imprimé essentiellement dans le même plan que le premier pôle de contact (15)

4. Appareil de cuisine selon la revendication 1, **caractérisé en ce que** le premier pôle de contact (15) réalisé comme secteur annulaire présente un angle au centre de notamment 45° à 350°, de manière préférée de 45° à 270°, de manière particulièrement préférée de 45° à 190°.

5. Appareil de cuisine selon l'une quelconque des revendications précédentes, **caractérisé en ce que** les pôles de contact (15, 16) sur le circuit imprimé (12) sont imprimés en tant que couche résistive.

6. Appareil de cuisine selon l'une quelconque des revendications précédentes, **caractérisé en ce que** le pont de commutation (20) comprend un matériau électroconducteur et présente en outre un premier et un deuxième contacts glissants (21, 22) qui sont réalisés pour mettre en contact électrique les pôles de contact correspondants (15, 16).

7. Appareil de cuisine selon la revendication 6, **caractérisé en ce que** les contacts glissants (21, 22) présentent respectivement deux languettes flexibles (21a, 22a) avec point de contact (31, 32) destinées à mettre en contact les pôles de contact (15, 16).

8. Appareil de cuisine selon l'une quelconque des revendications précédentes, **caractérisé en ce que** le pont de commutation (20) est fixé dans une douille (25) qui est réalisée comme partie d'un bouton rotatif (40) de l'appareil de cuisine.

9. Appareil de cuisine selon l'une quelconque des revendications précédentes, **caractérisé en ce que** le pont de commutation (20) coopère avec le premier pôle de contact (15) de manière à ce qu'une valeur de résistance réglable puisse être fournie pour la commande du moteur électrique de l'appareil de cuisine.
